# EUROPÄISCHE PATENTSCHRIFT

(11) **EP 0 651 504 B1**
(45) Veröffentlichungstag und Bekanntmachung des Hinweises auf die Patenterteilung: **02.12.1998**
(21) Anmeldenummer: 94110330.1
(22) Anmeldetag: 04.07.1994
(51) Int. Cl.: H03H 9/05, H03H 9/09, H03H 9/19, H03H 9/17

(54) **Halterung für Schwingquarzscheiben**
Holder for a quartz resonator disc
Support pour un résonateur à quartz à disque

(30) Priorität: 27.10.1993 DE 4336622
(43) Veröffentlichungstag der Anmeldung: 03.05.1995
(73) Patentinhaber: Schott Glas, 55122 Mainz (DE)
(72) Erfinder: Heimerl, Dieter, D-84036 Landshut (DE)

(56) Entgegenhaltungen:
- DE-A- 1 810 172
- US-A- 2 831 989
- US-A- 4 511 820
- US-A- 4 706 350

## Beschreibung

Die Erfindung betrifft eine Halterung für Schwingquarzscheiben mit einer Bodenplatte, mit zwei isoliert in der Bodenplatte befestigten Stromdurchführungsstiften, die jeweils eine Fahne mit einem Aufnahmeabschnitt zum Halten des Randbereiches der Schwingquarzscheibe aufweisen, und mit einem mittleren Kontaktstift, der elektrisch leitend mit der Bodenplatte verbunden ist, die auf ihrer Oberseite eine Aufnahmenut aufweist, in der der Rand der Schwingquarzscheibe eingreift.

Die wichtigste Eigenschaft eines mit Hilfe der genauen Eigenfrequenz des Quarzkristalls realisierten Filters bzw. Oszillators ist die Frequenzstabilität. Dabei ist es wichtig, daß beim Montieren, insbesondere während des Aufschweißens der Schutzkappe, bei Temperaturänderung oder nach Alterung die Halterung der Schwingquarzscheibe keine mechanischen Spannungen aufbaut, die zu unerwünschten Frequenzänderungen führen können. Auch darf die Halterung bei mechanischer Belastung die Schwingquarzscheibe nicht soweit belasten, daß dies zum Bruch führt.

Bei der Anwendung von Schwingquarzscheiben als Filter muß diese an drei Stellen kontaktiert werden. Die Halterung für die Schwingquarzscheibe weist dementsprechend drei Kontaktstifte auf, wobei die äußeren Kontaktstifte durch die Bodenplatte der Halterung hindurchgeführt sind und entweder zur Ausbildung von Aufnameabschnitten flachgequetscht sind oder aufgeschweißte Federelemente aufweisen. Der mittlere Kontaktstift ist leitend mit der Bodenplatte verbunden, auf deren Oberseite eine Mittelgabel metallisch leitend befestigt ist, in die die Schwingquarzscheibe mit ihrem Randbereich eingreift.

Mittels eines elektrisch leitenden Klebers wird die Schwingquarzscheibe in der Mittelgabel und in den Aufnahmeabschnitten der äußeren Kontaktstifte fixiert.

Die Schwingquarzscheibe liegt außer an den Punkten, wo sie mittels eines Kleber fixiert ist, noch an weiteren Punkten an der Halterung an, so daß bei auftretenden mechanischen Belastungen Risse und Brüche von diesen Haltepunkten der Schwingquarzscheibe mit der Halterung ausgehen.

Ein weiteres Problem betrifft die Bauhöhe des fertig montierten Quarzgehäuses. Bei gegebenem Durchmesser der Schwingquarzscheibe kann die Baugröße durch Segmentierung der Schwingquarzscheibe und entsprechend niedriger Verschlußkappe zwar verringert werden, die Schwingquarzscheibe kann jedoch aus folgenden Gründen nicht direkt auf die Platine aufgebracht werden. Die geschweißte Mittelgabel erfordert nämlich einen Freiraum zwischen der Gabel und der Oberfläche der Bodenplatte zum Ausgleich von Toleranzschwankungen bezüglich der Position der Schwingquarzscheibe in den beiden äußeren Halterungen. Bei geschweißten äußeren Halterungen muß hingegen eine gewisse Mindestsockelhöhe eingehalten werden, so daß auch die Mittelgabel in entsprechendem Abstand auf der Bodenplatte montiert sein muß. Bei integrierten Mittelgabeln ist wiederum eine Mindestbügelbreite im Ansetzbereich der Bodenplatte erforderlich, so daß der Aufnahmebereich für die Schwingquarzscheibe in vorgegebenem Abstand oberhalb der Bodenplatte vorgesehen ist.

Anstelle einer Mittelgabel ist gemäß der DE-OS 22 39 685 im Mittelbereich der Bodenplatte eine Anhebung vorgesehen, die über die Oberfläche der Bodenplatte hinausragt. In diese Anhebung ist eine schlitzförmige Vertiefung in Form einer Aufnahmenut vorgesehen, welche bei der Herstellung der Bodenplatte gleichzeitig angebracht werden kann. Die Vertiefung ist so breit ausgebildet, daß die Kante der Schwingquarzscheibe eingesetzt werden kann und darin Halt findet. Auf der der Anhebung gegenüberliegenden Seite ist bei der Herstellung der Bodenplatte eine Vertiefung angebracht, in welche das Ende des mittleren Kontaktstiftes ragt. Auch bei dieser bekannten Halterung ist die Bauhöhe vergleichbar mit solchen Halterungen, die eine Mittelgabel aufweisen.

Ein weiterer Nachteil bei dieser bekannten Halterung gemäß der DE-OS 22 39 685 besteht darin, daß die Fahnen flach ausgebildet und V-förmig abgewinkelt sind. Die Öffnungen des V-förmigen Teils sind gegeneinander ausgerichtet und die Vertiefungen dienen zum Einstecken der Schwingquarzscheibe. Die Schwinquarzscheibe, deren Rand gerade geschnitten sein muß, liegt somit im gesamten Bereich an den Aufnahmeabschnitten an, so daß die Schwingquarzscheibe insgesamt stark eingespannt ist, so daß mechanische Spannungen ebenfalls zu erheblichen Beschädigungen der Schwingquarzscheibe führen.

Aufgabe der Erfindung ist daher eine Halterung von Schwingquarzscheiben in dreipoliger Ausführung, mit der die mechanische Schockfestigkeit verbessert und eine möglichst geringe Bauhöhe erreicht wird.

Diese Aufgabe wird mit einer Halterung gemäß Patentanspruch 1 gelöst. Vorteilhafte Ausgestaltungen sind Gegenstand der Unteransprüche.

Die Erfindung geht aus von integrierten Aufnehmern, d.h. Quarzaufnehmern, die mit den Stromdurchführungen aus einem einzigen Teil hergestellt sind und bei denen der Stromdurchführungsstift am oberen Ende zur Aufnahme der Schwingquarzscheibe ausgebildet ist. Die durch diese Art der Stromdurchführungsstifte erreichte geringe Bauhöhe kann bei der dreipoligen Ausführung einer Schwingquarzhalterung dann vollständig realisiert werden, wenn erfindungsgemäß die Aufnahmenut innerhalb der Bodenplatte ausgebildet ist. Dadurch kann die Schwingquarzscheibe so weit abgesenkt montiert werden, daß der untere Randbereich der Schwingquarzscheibe in der Bodenplatte verschwindet.

Vorzugsweise ist die Aufnahmenut breiter als die Dicke der Schwingquarzscheibe, so daß diese zur Kontaktierung in einem elektrisch leitenden Kleber eingebettet werden kann.

Eine weitere Verringerung der Bautiefe kann erreicht werden, wenn die Nut als Doppelnut ausgebildet ist, wobei die zweite Nut schmaler als die erste Nut ausgebildet ist und die zweite Nut innerhalb der ersten Nut in die Bodenplatte eingebracht ist. Hierbei dient die zweite Nut zur Fixierung der Schwingquarzscheibe und die erste Nut zur Aufnahme des elektrisch leitenden Klebers, wobei die Tiefe der ersten Nut vorzugsweise derart an die Dicke des aufgebrachten Klebers angepaßt ist, daß dieser nicht gegenüber der Oberseite der Bodenplatte vorsteht.

Gemäß einer Ausführungsform kann die Breite der zweiten Nut der Dicke der Schwingquarzscheibe entsprechen, so daß bei der Montage der Schwingquarzscheibe vor dem Aufbringen des Klebers eine Lagefixierung im unteren Bereich der Schwingquarzscheibe ermöglicht wird.

Die Verbesserung der mechanischen Schockfestigkeit der Halterung wird dadurch erreicht, daß die Schwingquarzscheibe außer an dem zuvor beschriebenen Befestigungspunkt lediglich noch an zwei weiteren Befestigungspunkten gehalten wird. Jeder Aufnahmeabschnitt der Stromdurchführungsstifte ist derart ausgebildet, daß er nur an einem Befestigungspunkt an der Schwingquarzscheibe angreift. Unter einem solchen Befestigungspunkt wird ein Berührungspunkt von Schwingquarzscheibe und Aufnahmeabschnitt verstanden, an dem der Aufnahmeabschnitt unter Federspannung an der Schwingquarzscheibe anliegt. Bei diesen Befestigungspunkten ist die angreifende Kraftkomponente parallel zur Scheibenfläche gerichtet.

Es hat sich herausgestellt, daß mechanische Spannungen auf die Schwingquarzscheibe dann am besten ohne Beschädigung der Schwingquarzscheibe aufgenommen werden können, wenn die drei Befestigungspunkte derart angeordnet sind, daß sie ein etwa gleichseitiges Dreieck bilden.

Vorzugsweise ist die Schwingquarzscheibe an diesen drei gleichmäßig über den Umfang der Schwingquarzscheibe verteilten Befestigungspunkte mittels eines elektrisch leitenden Klebers an der Halterung fixiert.

Gemäß einer besonderen Ausführungsform besitzen die Fahnen in ihrem Aufnahmeabschnitt zum Eingreifen des Randbereiches der Schwingquarzscheibe jeweils einen Schlitz mit einer solchen Länge, daß der untere Abschnitt der Scheibe bei eingesetzter Schwingquarzscheibe frei bleibt. Bei dieser Ausführungsform liegt der Aufnahmeabschnitt lediglich mit dem oberen Endbereich des Schlitzes am Umfangsrand der Schwingquarzscheibe an, so daß die Schwingquarzscheibe am unteren Ende des Schlitzes die Halterung nicht berührt.

Die Schlitzbreite muß nicht gleich der Dicke der Schwingquarzscheibe sein, sondern kann auch größer sein, da die Schwingquarzscheibe im Befestigungspunkt mittels des elektrisch leitenden Klebers gegen seitliches Verrutschen fixiert ist.

Um Fertigungstoleranzen der Schwingquarzscheibe und bei Temperaturänderungen bzw. beim Verschweißen des Schwingquarzes möglicherweise auftretende Spannungen abzubauen sowie die Flexibilität in vertikaler Richtung zu erhöhen, können die beiden Stromdurchführungsstifte mit einer zusätzlichen Ausformung versehen sein, die sich vorzugsweise von der Schwingquarzscheibe weg erstreckt. Dadurch wird ein Federelement gebildet, das eine zusätzliche Flexibilität in vertikaler Richtung der Fahne gewährleistet.

Die Flexibilität der Ausformung in vertikaler Richtung kann dadurch noch erhöht werden, daß sich der Schlitz bis in die Ausformung erstreckt, damit sichergestellt ist, daß die Schwingquarzscheibe im Hinblick auf eine 3-Punkt-Aufhängung die Fahne am unteren Ende des Schlitzes nicht berührt. Die Ausformung kann auf verschiedene Weise, als Schleife oder dergleichen ausgebildet sein, wobei darauf geachtet werden muß, daß die Ausgestaltung sowohl die Anforderung an Flexibiltiät aber auch an notwendiger Steifigkeit erfüllt. Bei zu großer Flexibilität könnte im Falle von Erschütterungen die Schwingquarzscheibe so weit ausgelenkt werden, daß sie gegen die Außenwand schlägt. Auch muß die Ausformung so gestaltet sein, daß die nach der Montage des Schwingquarzes zum hermetischen Abschluß erforderliche Kappe über dem Schwingquarz mit diesem nicht in Berührung kommt.

Beispielshafte Ausführungsformen der Erfindung werden nachfolgend anhand der Zeichnungen näher erläutert.

Es zeigen:
- Figur 1: eine Frontalansicht einer Schwingquarzhalterung, wobei die Bodenplatte im Schnitt dargestellt ist,
- Figur 2: die in Figur 1 gezeigte Halterung im Schnitt längs der Linie II-II in perspektivischer Darstellung,
- Figur 3: eine Ausführungsform eines Stromdurchführungsstiftes in Seitenansicht und
- Figur 4: den in Figur 3 gezeigten Stromdurchführungsstift in einer weiteren Seitenansicht.

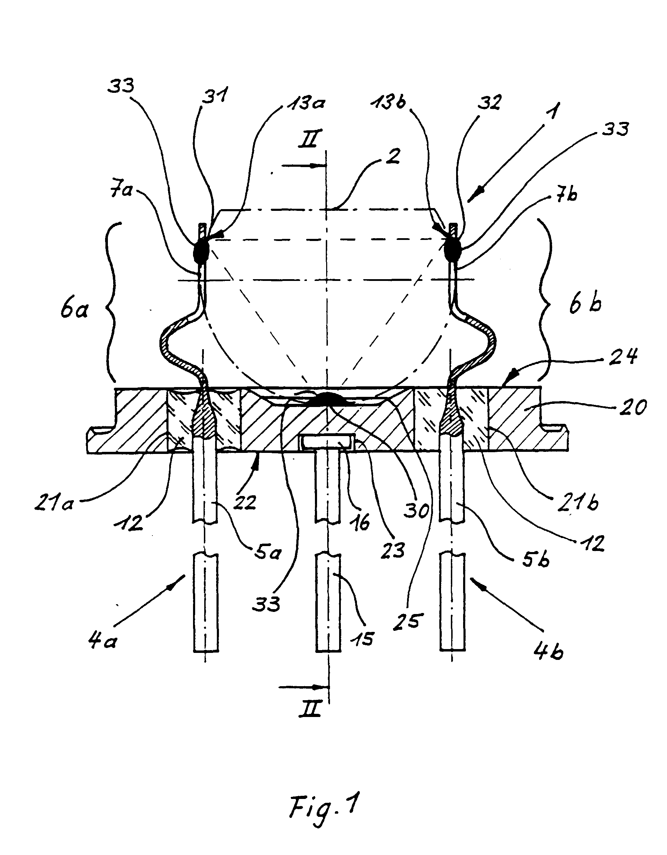

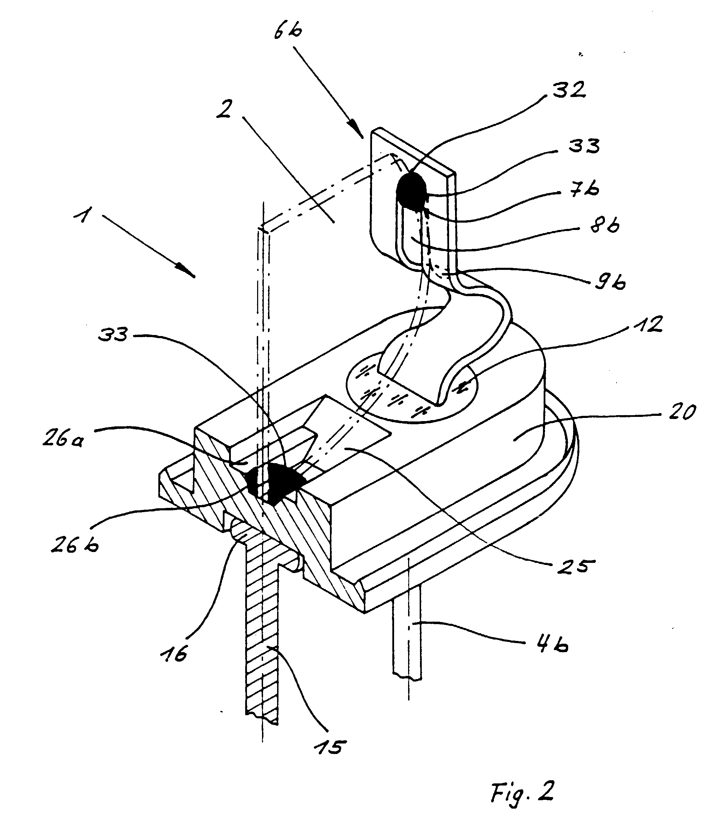

In der Figur 1 ist eine Halterung 1 in dreipoliger Ausführung dargestellt. Zwei Stromdurchführungsstifte 4a, 4b sind in Bohrungen 21a, 21b einer Bodenplatte 20 mittels eines Einschmelzmaterials 12 befestigt. Die Stiftabschnitte 5a, 5b erstrecken sich bis in das Einschmelzmaterial 12 und gehen dann in die Fahnen 6a, 6b über. Die Fahnen 6a, 6b besitzen jeweils einen Schlitz 8a, 8b (s. Figur 2) im jeweiligen Aufnahmeabschnitt 7a, 7b, in denen der jeweilige Randbereich der Schwingquarzscheibe 2 eingreift, die lediglich am oberen Abschnitt 13a, 13b des Schlitzes 8a, 8b anliegt, wo somit jeweils ein Befestigungspunkt 31, 32 gebildet wird. An diesen Befestigungspunkten 31, 32 ist die Schwingquarzscheibe mittels eines elektrisch leitenden Klebers 33 fixiert.

An der Unterseite 22 der Bodenplatte 20, die aus Kovar (eingetragenes Warenzeichen) oder Stahl bestehen kann, ist in einer Ausnehmung 23 der mittlere Kontaktstift 15 mit seinem Nagelkopf 16 bündig eingesetzt. Der Kontaktstift 15 kann beispielsweise eingelötet oder eingeschweißt sein. Auf der dem mittleren Kontaktstift 15 gegenüberliegenden Seite der Bodenplatte 20 ist eine Nut 25 eingebracht, in die der untere Randbereich der Schwingquarzscheibe 2 eingreift. Die Länge der Nut 25 ist größer als der in die Bodenplatte 20 eintauchende Randbereich der Schwingquarzscheibe 2, so daß diese mit ihrer Umfangsfläche nicht an der Bodenplatte 20 anliegt. Zur Ausbildung eines unteren Befestigungspunktes 30 ist die Schwingquarzplatte 2 in den elektrisch leitenden Kleber 33 eingebettet. Wie aus der Figur 1 zu entnehmen ist, bilden die drei Befestigungspunkte 30, 31 und 32 etwa ein gleichseitiges Dreieck.

In der Figur 2 ist ein Schnitt längs der Linie II-II der in Figur 1 gezeigten Halterung 1 in perspektivischer Darstellung zu sehen. Der Schlitz 8b erstreckt sich so weit in Richtung Bodenplatte 20, daß der untere Abschnitt 9b des Schlitzes 8b frei bleibt und nicht am Umfangsrand der Schwingquarzscheibe 2 anliegt. Dadurch wird erreicht, daß die Fahne 6b lediglich im Befestigungspunkt 32 an der Schwingquarzscheibe 2 anliegt.

In der in Figur 2 gezeigten Darstellung ist die Nut 25 als Doppelnut 26a, 26b ausgebildet. Die erste Nut 26a ist deutlich breiter ausgeführt als die zweite Nut 26b, die zur Aufnahme und Fixierung des Randbereiches der Schwingquarzplatte 2 dient. Die zweite Nut 26b kann gleiche Breite aufweisen wie die Dicke der Schwingquarzscheibe 2. In der hier gezeigten Darstellung ist jedoch die Breite der zweiten Nut 26b etwas größer als die Dicke der Schwingquarzscheibe 2, so daß auch in diesem Bereich die Schwingquarzscheibe im Kleber 33 eingebettet ist. Die Tiefe der ersten Nut 26a ist vorzugsweise so gewählt, daß der Kleber 33 nicht gegenüber der Oberseite 24 der Bodenplatte 20 vorsteht.

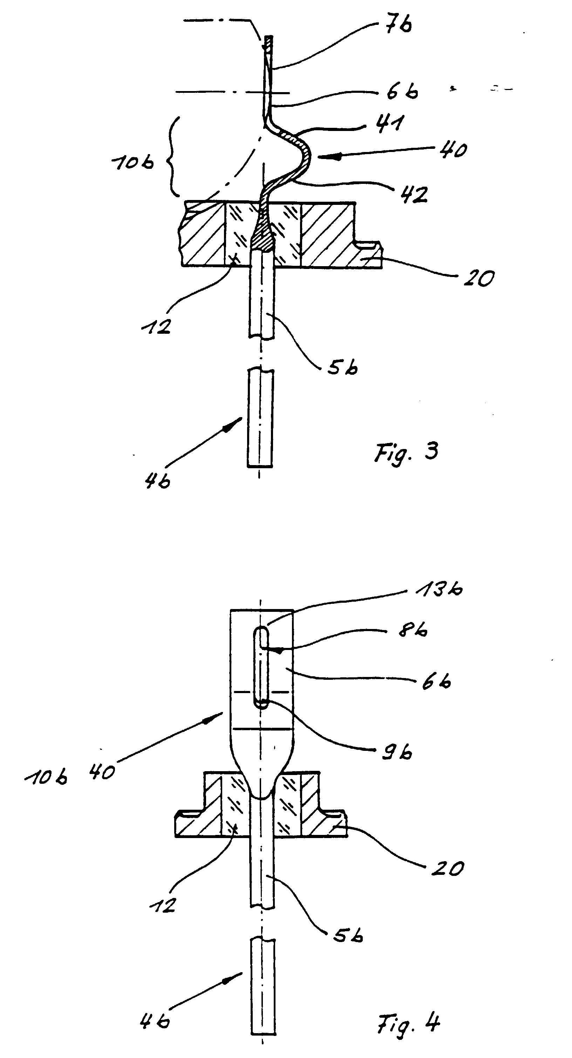

In der Figur 3 ist eine weitere Ausführungsform eines Stromdurchführungsstiftes 4b dargestellt. Oberhalb der Bodenplatte 20 geht der Stiftabschnitt 5b zunächst in eine Ausformung 40 über, an die sich die Fahne 6b anschließt. Die Ausformung 40 kann wie der Aufnahmeabschnitt 7b flachgequetscht sein und somit Bestandteil der Fahne 6b sein. Die Ausformung 40 wird durch eine Schleife gebildet und stellt somit ein Federelement dar, das eine zusätzliche Flexibilität in vertikaler Richtung der Fahne 6b gewährleistet. Die Länge und die Radien der Abschnitte 41, 42 des Federelementes werden in der Konstruktion den Anforderungen an die Flexibiltität angepaßt.

In der Figur 4 ist eine Seitenansicht der in Figur 3 gezeigten Ausführungsform des Stromdurchführungsstiftes 4b zu sehen. Der Schlitz 8b erstreckt sich mit seinem unteren Abschnitt 9b bis in diesen Bereich der Ausformung 40.

### Bezugszeichenliste:

- 1: Schwingquarzhalterung
- 2: Schwingquarzscheibe
- 4a, b: Stromdurchführungsstift
- 5a, b: Stiftabschnitt
- 6a, b: Fahne
- 7a, b: Aufnahmeabschnitt
- 8a, b: Schlitz
- 9a, b: unterer Abschnitt des Schlitzes
- 10a, b: unterer Abschnitt der Fahne
- 12: Einschmelzmaterial
- 13a, b: oberer Abschnitt des Schlitzes
- 15: mittlerer Kontaktstift
- 16: Nagelkopf
- 20: Bodenplatte
- 21a, b: Bohrung
- 22: Unterseite
- 23: Ausnehmung
- 24: Oberseite
- 25: Nut
- 26a, b: Doppelnut
- 30: Befestigungspunkt
- 31: Befestigungspunkt
- 32: Befestigungspunkt
- 33: Kleber
- 40: Ausformung
- 41: gerader Abschnitt
- 42: gerader Abschnitt
- 43: gekrümmter Abschnitt

## Patentansprüche

1. Halterung für Schwingquarzscheiben mit einer Bodenplatte, mit zwei isoliert in der Bodenplatte befestigten Stromdurchführungsstiften, die jeweils eine Fahne mit einem Aufnahmeabschnitt zum Halten des Randbereiches der Schwingquarzscheibe aufweisen, und mit einem mittleren Kontaktstift, der elektrisch leitend mit der Bodenplatte verbunden ist, die auf ihrer Oberseite eine Aufnahmenut aufweist, in der der Rand der Schwingquarzscheibe eingreift, dadurch gekennzeichnet,
daß die Aufnahmenut (25) innerhalb der Bodenplatte (20) ausgebildet ist und
daß jeder Aufnahmeabschnitt (7a, b) derart ausgebildet ist, daß er nur an einem Befestigungspunkt (31, 32) an der Schwingquarzscheibe (2) angreift.

2. Halterung nach Anspruch 1, dadurch gekennzeichnet, daß die Befestigungspunkte (31, 32) derart angeordnet sind, daß sie mit dem in der Aunahmenut (25) befindlichen Befestigungspunkt (30) ein etwa gleichseitiges Dreieck bilden.

3. Halterung nach Anspruch 1 oder 2, dadurch gekennzeichnet, daß die Schwingquarzscheibe (2) an den drei etwa gleichmäßig über den Umfang der Schwingquarzscheibe (2) verteilten Befestigungspunkten (30 - 32) mittels eines elektrisch leitenden Klebers (33) an der Halterung (1) fixiert ist.

4. Halterung nach einem der Ansprüche 1 bis 3, dadurch gekennzeichnet, daß die Fahnen (6a, b) in ihren Aufnahmeabschnitten (7a, b) zum Eingreifen des Randbereiches der Schwingquarzscheibe (2) jeweils einen Schlitz (8a, b) mit einer solchen Länge aufweisen, daß der untere Abschnitt (9a, b) des Schlitzes (8a, b) bei eingesetzter Schwingquarzscheibe (2) frei bleibt.

5. Halterung nach einem der Ansprüche 1 bis 4, dadurch gekennzeichnet, daß die Nut (25) breiter als die Dicke der Schwingquarzscheibe (2) ist, und daß die Schwingquarzscheibe (2) in der Aufnahmenut (25) in einem elektrisch leitenden Kleber (33) eingebettet ist.

6. Halterung nach einem der Ansprüche 1 bis 5, dadurch gekennzeichnet, daß die Aufnahmenut (25) als Doppelnut (26a, b) ausgebildet ist, wobei die zweite Nut (26b) schmaler als die erste Nut (26a) und innerhalb der ersten Nut (26a) ausgebildet ist.

7. Halterung nach Anspruch 6, dadurch gekennzeichnet, daß die Breite der zweiten Nut (26b) der Dicke der Schwingquarzscheibe (2) entspricht.

8. Halterung nach einem der Ansprüche 6 oder 7, dadurch gekennzeichnet, daß die Tiefe der ersten Nut (26a) derart an die Dicke des aufgebrachten Klebers (33) angepaßt ist, daß dieser nicht gegenüber der Oberseite (24) der Bodenplatte (20) vorsteht.

9. Halterung nach einem der Ansprüche 1 bis 8, dadurch gekennzeichnet, daß die Schwingquarzscheibe (2) am jeweils oberen Schlitzabschnitt (13a, b) mittels eines Klebers (33) an den Fahnen (6a, 6b) fixiert ist.

10. Halterung nach einem der Ansprüche 1 bis 9, dadurch gekennzeichnet, daß die Fahnen (6a, b) im unteren Fahnenabschnitt (10a, b) eine Ausformung (40) aufweisen.

11. Halterung nach Anspruch 10, dadurch gekennzeichnet, daß sich die untere Ausformung (40) von der Schwingquarzscheibe (2) weg erstreckt.

12. Halterung nach einem der Ansprüche 10 oder 11, dadurch gekennzeichnet, daß sich der Schlitz (8a, b) bis in die Ausformung (40) erstreckt.

## Claims

1. Mounting for quartz-oscillator discs, having a base plate, having two current feed-through pins, which are fastened in an insulated manner in the base plate and respectively exhibit a flag having a receiving section for holding the marginal region of the quartz-oscillator disc, and having a central contact pin connected in an electrically conductive manner to the base plate, which, on its top side, exhibits a receiving groove in which the rim of the quartz-oscillator disc engages, characterized in that the receiving groove (25) is configured within the base plate (20), and in that each receiving section (7a, b) is configured such that it acts only at one fastening point (31, 32) upon the quartz-oscillator disc (2).

2. Mounting according to Claim 1, characterized in that the fastening points (31, 32) are disposed such that they form with the fastening point (30) located in the receiving groove (25) an approximately equilateral triangle.

3. Mounting according to Claim 1 or 2, characterized in that the quartz-oscillator disc (2) is secured on the mounting (1), at the three fastening points (30 - 32) approximately evenly distributed over the periphery of the quartz-oscillator disc (2), by means of an electrically conductive adhesive (33).

4. Mounting according to one of Claims 1 to 3, characterized in that the flags (6a, b) exhibit in their receiving sections (7a, b), for the engagement of the marginal region of the quartz-oscillator disc (2), a respective slot (8a, b) of sufficient length that the lower section (9a, b) of the slot (8a, b) remains free whenever the quartz-oscillator disc (2) is inserted.

5. Mounting according to one of Claims 1 to 4, characterized in that the groove (25) is wider than the thickness of the quartz-oscillator disc (2), and in that the quartz-oscillator disc (2) is embedded in the receiving groove (25) in an electrically conductive adhesive (33).

6. Mounting according to one of Claims 1 to 5, characterized in that the receiving groove (25) is configured as a double groove (26a, b), the second groove (26b) being configured narrower than the first groove (26a) and within the first groove (26a).

7. Mounting according to Claim 6, characterized in that the width of the second groove (26b) corresponds to the thickness of the quartz-oscillator disc (2).

8. Mounting according to Claim 6 or 7, characterized in that the depth of the first groove (26a) is matched to the thickness of the applied adhesive (33) such that this does not project relative to the top side (24) of the base plate (20).

9. Mounting according to one of Claims 1 to 8, characterized in that the quartz-oscillator disc (2) is secured at the respective upper slot section (13a, b) to the flags (6a, b) by means of an adhesive (33).

10. Mounting according to one of Claims 1 to 9, characterized in that the flags (6a, b) exhibit in the lower flag section (10a, b) a form-out (40).

11. Mounting according to Claim 10, characterized in that the lower form-out (40) extends away from the quartz-oscillator disc (2).

12. Mounting according to one of Claims 10 or 11, characterized in that the slot (8a, b) extends into the form-out (40).

## Revendications

1. Support pour un résonateur à quartz à disque comprenant une plaque de fond, avec deux broches conductrices du courant fixées dans la plaque de fond isolées, qui possèdent chacune une queue non conductrice avec une section de support pour recevoir la zone de bord du résonateur à quartz à disque, et avec une broche de contact médiane, qui est reliée à la plaque de fond de manière à conduire l'électricité, lequel support présente sur sa face supérieure une rainure de logement dans laquelle s'insère le bord du résonateur à quartz à disque, caractérisé en ce que la rainure de logement (25) est réalisée à l'intérieur de la plaque de fond (20) et en ce que chaque section de support (7a, b) est conçue de telle manière qu'elle n'entre en contact avec le résonateur à quartz à disque (2) qu'en un point de fixation (31, 32).

2. Support suivant la revendication 1, caractérisé en ce que les points de fixation (31, 32) sont agencés de telle manière qu'ils forment avec le point de fixation (30) situé dans la rainure de logement (25) un triangle approximativement équilatéral.

3. Support suivant la revendication 1 ou 2, caractérisé en ce que le résonateur à quartz à disque (2) est fixé sur le support (1) aux trois points de fixation (30 à 32) répartis de façon approximativement uniforme sur le périmètre du résonateur à quartz à disque (2) au moyen d'une colle (33) conductrice de l'électricité.

4. Support suivant l'une quelconque des revendications 1 à 3, caractérisé en ce que les queues non conductrices (6a, b) présentent chacune dans leur section de support (7a, b), en vue d'enserrer la zone de bord du résonateur à quartz à disque (2), une fente (8a, b) d'une longueur telle que la section inférieure (9a, b) de la fente (8a, b) reste libre lorsque le résonateur à quartz à disque (2) est inséré.

5. Support suivant l'une quelconque des revendications 1 à 4, caractérisé en ce que la rainure (25) possède une largeur supérieure à l'épaisseur du résonateur à quartz à disque (2) et en ce que le résonateur à quartz à disque (2) est noyé dans la rainure de logement (25) dans une colle (33) conductrice de l'électricité.

6. Support suivant l'une quelconque des revendications 1 à 5, caractérisé en ce que la rainure de logement (25) est réalisée sous la forme d'une double rainure (26a, b), la deuxième rainure (26b) étant plus étroite que la première rainure (26a) et réalisée à l'intérieur de la première rainure (26a).

7. Support suivant la revendication 6, caractérisé en ce que la largeur de la deuxième rainure (26b) correspond à l'épaisseur du résonateur à quartz à disque (2).

8. Support suivant l'une quelconque des revendications 6 ou 7, caractérisé en ce que la profondeur de la première rainure (26a) est adaptée à l'épaisseur de la colle déposée (33) de telle sorte que celle-ci n'atteigne pas la face supérieure (24) de la plaque de fond (20).

9. Support suivant l'une quelconque des revendications 1 à 8, caractérisé en ce que le résonateur à quartz à disque (2) est fixé aux queues non conductrices (6a, 6b) dans chaque section supérieure de fente (13a, b) au moyen d'une colle (33).

10. Support suivant l'une quelconque des revendications 1 à 9, caractérisé en ce que les queues non conductrices (6a, b) présentent une courbure (40) dans leur section inférieure (10a, b).

11. Support suivant la revendication 10, caractérisé en ce que la courbure inférieure (40) s'étend à l'opposé du résonateur à quartz à disque (2).

12. Support suivant la revendication 10 ou 11, caractérisé en ce que la fente (8a, b) s'étend jusqu'à l'intérieur de la courbure (40).
